# EUROPEAN PATENT APPLICATION

(11) **EP 4 579 666 A1**
(43) Date of publication of application: **02.07.2025**
(21) Application number: 24214032.5
(22) Date of filing: 19.11.2024
(51) Int. Cl.: G11C 29/16, G11C 29/44, G11C 29/52, G11C 29/18, G11C 29/46, G11C 29/04

(54) **MEMORY BUILT-IN SELF-TEST (MBIST) AND BIST ADAPTIVE PORT (BAP) FOR PERIODIC IN-FIELD TESTING**

(30) Priority: 29.12.2023 US 202318401067
(71) Applicant: INTEL Corporation, Santa Clara, CA 95054 (US)
(72) Inventor: KANDULA, Rakesh, 560035 Bangalore (IN); SU, Fei, Ann Arbor, MI 48105 (US)
(74) Representative: HGF

(57) **Abstract**

A BIST (built-in self-test) adaptive port (BAP) interface enables an in-field MBIST (memory BIST). The BAP enables non-destructive testing of the memory locations. The BAP includes registers to store contents of the memory device during the in-field MBIST on the memory device. The BAP can store the starting address of the next infield periodic testing and operational data from a selected memory address in the registers while the MBIST controller performs the test on the memory address. The system can then restore the operational contents of the memory after the test is complete.

## Description

### TECHNICAL FIELD

Descriptions are generally related to memory devices, and more particular descriptions are related to memory testing.

### BACKGROUND OF THE INVENTION

Memory is deployed wherever there is a computer system. The memory stores operational data and runtime instructions. Whether the memory is volatile memory, which has indeterminate state if power to the memory is interrupted, or the memory is nonvolatile memory, which maintains determinate state even if power to the memory is interrupted, memory is known to experience errors. The errors range from transient errors to permanent errors with a memory location.

Systems can have a BIST (built-in self-test) to perform testing for errors. MBIST (memory built-in self-test) is a self-testing and repair mechanism which tests the memories through an effective set of algorithms to detect faults that could be present inside a typical memory cell. The faults can be SAF (stuck-at fault), TDF (transition delay faults), CF (coupling fault), or NPSF (neighborhood pattern sensitive faults). MBIST uses an inbuilt clock, address, data generators, and read/write controller logic to generate the test patterns for the test.

Typically, the memory testing is performed after the computer system is built and configured, and before the system is deployed or during a diagnostic or testing mode where the computing system is not operational. Current MBIST cannot be performed in-field during operational mode because the testing time for the number of addresses is too long to fit within an acceptable testing window. Additionally, the testing requires writing of the memory locations, which would be destructive to the operational data stored in the memory.

### BRIEF DESCRIPTION OF THE DRAWINGS

The following description includes discussion of figures having illustrations given by way of example of an implementation. The drawings should be understood by way of example, and not by way of limitation. As used herein, references to one or more examples are to be understood as describing a particular feature, structure, or characteristic included in at least one implementation of the invention. Phrases such as "in one example" or "in an alternative example" appearing herein provide examples of implementations of the invention, and do not necessarily all refer to the same implementation. However, they are also not necessarily mutually exclusive.
**Figure 1** is a block diagram of an example of a BIST system.
**Figure 2** is a block diagram of an example of a BAP interface.
**Figure 3** is a sequence diagram of periodic in-field testing with a BIST system.
**Figure 4** is a flow diagram of an example of a process for performing in-field MBIST.
**Figures 5A-5B** are block diagrams of an example of a BIST interface for in-field predictive memory repair.
**Figure 6** is a flow diagram of an example of a process for performing in-field predictive memory repair.
**Figure 7** is a block diagram of an example of a computing system in which in-field MBIST can be implemented.
**Figure 8** is a block diagram of an example of a compact computing device in which in-field MBIST can be implemented.
**Figure 9** is a block diagram of an example of an SOC in which in-field MBIST can be implemented.

Descriptions of certain details and implementations follow, including non-limiting descriptions of the figures, which may depict some or all examples, and well as other potential implementations.

### DETAILED DESCRIPTION OF THE INVENTION

As described herein, a BIST (built-in self-test) adaptive port (BAP) interface enables an in-field MBIST (memory BIST) for an operational system. The BAP described herein enables non-destructive testing of the memory locations. The BAP includes registers to store contents of the memory device during the in-field MBIST operation on the memory device, where operational data from a selected memory address (the selected test addresses) is stored in the registers while the MBIST controller performs the test on the memory address. The system can then restore the operational contents of the memory after the test is complete.

What is described herein can be referred to as a universal MBIST and BAP for periodic infield applications to enable testing by an operational device. In one example, the system includes capability to enable predictive memory repair to predict memory failure and perform a predictive error repair operation even before catastrophic failure occurs. Thus, the system can perform a repair operation based on error prediction in addition to performing a repair operation based on error detection. The MBIST and BAP described can be applied in server devices, data centers (e.g., on blade devices), as well as embedded computing applications such as automotive SOCs (systems on a chip), banking systems, or other embedded application.

As described herein, a system can perform periodic infield testing on memories. Additionally, in one example, the system can predict failures in memory locations, and can optionally perform error correction. With internal registers or other small memory, the BAP interface can enable non-destructive memory testing, which allows for testing in an operational system. In one example, the BAP interface includes a register or other small memory to store an address of memory location under test, which can enable the system to perform partial testing in an individual testing window. Thus, the system can perform periodic testing that enables testing the entire memory device.

In one example, the BAP interface couples to a communication interface that enables the BAP to communicate directly to a user (e.g., providing a message on a user interface), to the OS (operating system) such as by sending a message to an OS memory controller, or to a cloud application that gathers and processes results of the periodic testing.

In one example, the system provides predictive repair of memories. In one example, the predictive repair occurs in response to sensor information from system sensors. The sensors can provide information to the BIST controller. In response to the sensor information, the BIST controller can compute a predicted error and trigger a corrective action before the memory suffers a catastrophic failure.

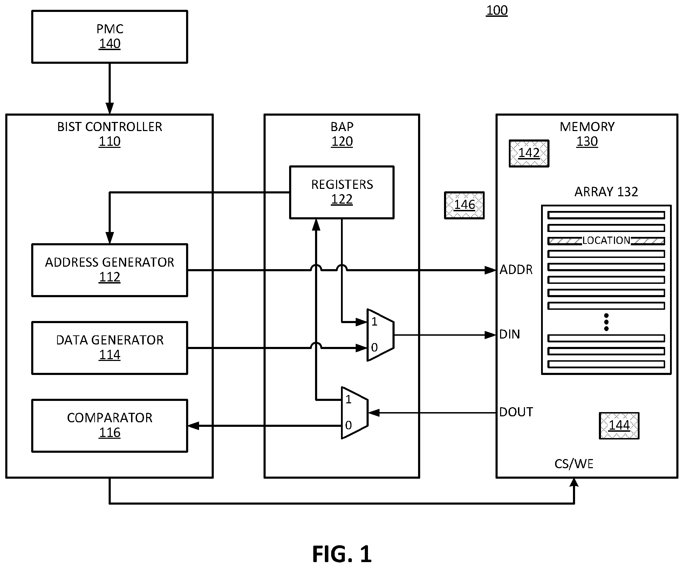

**Figure 1** is a block diagram of an example of a BIST system. System 100 includes BIST controller 110 coupled to memory 130 through BAP 120. In one example, system 100 is implemented as circuit on an SOC. In one example, system 100 is implemented as a circuit on a process/CPU (central processing unit) die for a memory embedded on the processor die.

Memory 130 represents any type of memory that can be embedded on an SOC or on a processor, such as an embedded memory device or an embedded memory circuit. Typically, memory 130 is a volatile memory, such as DRAM (dynamic random access memory) or SRAM (static random access memory). Memory 130 can be a cache memory.

Memory 130 includes array 132, which represents an array of bit cells where data is stored. Array 132 is illustrated as multiple memory locations, where a memory location has an address. In one example, each memory location represents an address or addressable location where data can be read and written.

BIST controller 110 can include address generator 112 as an internal address generation circuit to generate the addresses for the MBIST testing. In one example, address generation 112 can receive information from register 122 of BAP 120 to generate addresses based on a saved starting address. Thus, system 100 enables performing the MBIST in separate segments, which can be interrupted by periods of operation of memory 130. In one example, BIST controller 110 periodically triggers MBIST operations on a range of addresses for an MBIST session.

BIST controller 110 can include data generator 114 to generate test patterns to write to the addresses to be tested, which are indicated by address generator 112. After writing test data to the address of memory 130, BIST controller 110 can read the data back out of the memory location to determine if the memory location is free of defects. Comparator 116 enables BIST controller 110 to compare the generated data, which is the test data pattern, with the data read from the memory location. If they match, the memory location is free of defects. Detection of an error can trigger an error recovery action. The error recovery action can be passive, such as reporting the error, or active by performing a repair action on the data to be restored to the memory location.

BAP 120 represents the interface between BIST controller 110 and memory 130 and can be referred to as a BAP interface circuit. In one example, BAP 120 includes register 122. Registers 122 represent registers that can store the functional contents of a memory location. Thus, the memory testing can be non-destructive. In preparation for a memory test, consider that BAP 120 can generate a read request for the address of address generator 112. Memory 130 can provide the data contents at DOUT (data out), which BAP 120 can store in register 122.

After storing the data contents in BAP 120, BIST controller 110 can perform the memory testing at the address. After the test, BAP 120 can provide the functional contents from register 122 to restore to the ADDR (address) of array 132 from which it was read to enable testing. Thus, DIN (data in) can be the test data generated for the memory test or it can be the functional data to be restored after the test.

In one example, system 100 includes PMC (power management controller) 140. For purposes of system 100, PMC 140 can indicate to BIST controller 110 when memory 130 is idle. In one example, system 100 waits for memory 130 to be in an idle state to perform MBIST testing. In one example, memory 130 is in an idle state after power up. In one example, memory 130 is in an idle state from a lack of communication to the system, such as when a NIC (network interface circuit) controller is idle. In one example, sensor 142, sensor 144, and sensor 146 idle their control logic when memory 130, and the idle sensor state can act as a proxy to indicate that memory 130 is idle.

In the idle state the memory can be non-destructively tested as described, without interrupting active operation of the system. In one example, PMC 140 indicates when memory 130 is requested to awake from the idle state, so BIST controller 110 can pause the MBIST testing.

In one example, system 100 includes one or more smart sensors. Sensor 142 and sensor 144 represent sensors at different locations in memory 130. Sensor 146 represents a sensor outside of memory 130 that can monitor conditions related to memory 130. Each of the sensors can be a smart sensor in accordance with what is described in U.S. Patent Application No. 18/091,810.

More specifically, the sensors can be intelligent sensors that include a sensor circuit and also have logic circuitry to allow the sensor to send a notification to another entity, such as firmware or software. The logic circuitry enables the sensors to determine when data is data of interest, such as when a threshold is reached, when matching conditions occur, or some other computation that the sensor can perform based on data readings. By enabling the sensors to have logic to identify data of interest, system 100 can respond to data detected and indicated by the sensors instead of continuously polling all sensors and determining at a central controller when an event has occurred. In one example, sensor 142, sensor 144, and sensor 146 include one or more configurable parameters that a system controller can set. Thus, the system can set parameters of the sensors to trigger the sensors to monitor for specific conditions.

In one example, system 100 enables non-destructive memory testing through BAP 120. In other testing systems, BAP 120 might trigger BIST controller 110 to perform testing on memory 130, and the entire contents of memory 130 would first be stored in a different device (not shown in system 100). However, such a save and restore mechanism becomes may be impractical as the size of memories increases and number of memories to be tested infield goes up. System 100 provides a scalable solution where BAP 120 reads a small number of locations of memory at a time, saves them locally in registers 122, and triggers the tests. In one example, BAP 120 reads only two addresses per test operation. The test window can include many such test operations.

In one example, BAP 120 of system 100 is an interface that enables infield period testing partially in individual periodic testing windows. As mentioned above, each test window can include the performance of a series of test operations. In one example, the infield periodic testing window is a fixed and restricted amount time provided to perform the tests. The restriction on time can be set to ensure the testing does not interrupt the functional runtime of the system. It will be understood that the amount of time available for testing without interrupting system operation is insufficient to test the entire contents of memory 130. BAP 120 enables the splitting of the tests across multiple infield periodic sessions. In one example, BAP 120 saves the address of a particular memory up to which the previous infield testing session was performed. Registers 122 can include a register to store an address to mark how far prior testing was performed.

In one example, BAP 120 can communicate directly to an external entity. System 100 does not specifically illustrate the interface to communicate, nor the external entity. In one example, the communication interface is a functional bus interface that can access a bus of the functional system to communicate with the external entity. The functional bus is different than the TAP (test access port) interface or DFT (design for test) interface. Examples of functional bus interfaces can include AMBA (advanced microcontroller bus architecture), AXI (advanced extensible interface), APB (advanced peripheral bus), AHB (advanced high-performance bus), OCP bus (open core protocol - a protocol for on-chip subsystem communications), or any other bus.

In one example, BIST controller 110 and BAP 120 have controllers that execute firmware to control their operation. In one example, PMC commands from PMC 140 can be converted by BIST controller 110 or BAP 120 into TAP commands to manage the connection to memory 130. In one example, the firmware triggers BAP 120 to periodically look at memory segments of memory 130.

System 100 enables seamless execution of infield periodic tests on memory through BAP 120. In one example, system 100 enables predictive repair of memory 130 based on the sensors. Where current MBIST testing checks the memory in HVM (high volume manufacturing). System 100 enables in-field memory checking, which allows the system to monitor aging.

In one example, BIST controller 110 periodically triggers MBIST operations on a range of addresses of memory 130. In one example, BAP 120 triggers BIST controller 110 to periodically perform the MBIST operations. In one example, registers 122 include an address register to store an address location to indicate a next address to test in a subsequent MBIST session. In one example, registers 122 include data registers to store functional data from the address of the memory to be tested.

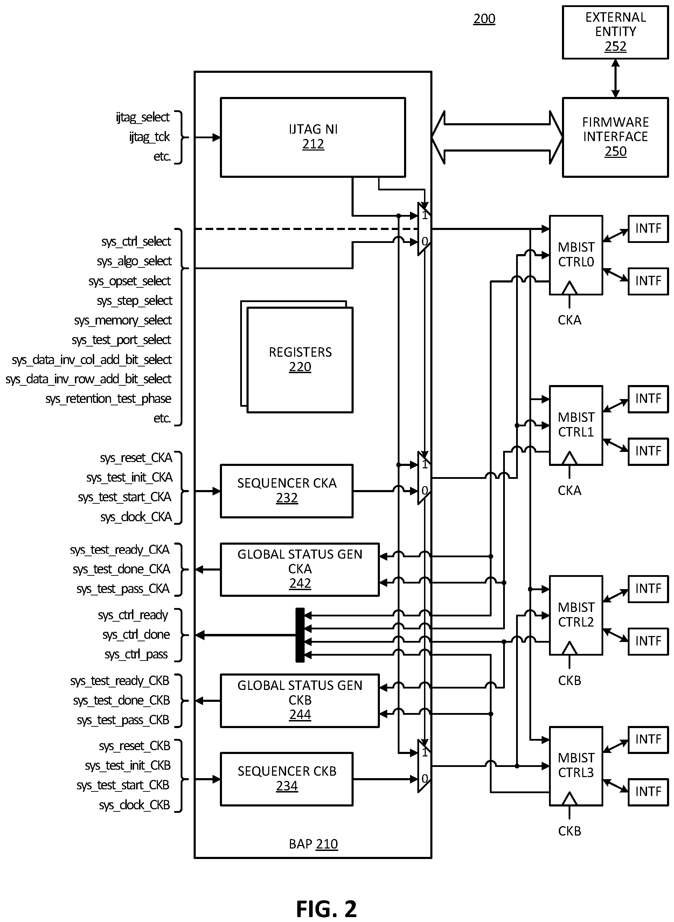

**Figure 2** is a block diagram of an example of a BAP interface. System 200 represents a system in accordance with an example of system 100. BAP 210 represents an example of BAP 120 of system 100. The MBIST controllers (MBIST CTRL0, MBIST CTRL1, MBIST CTRL2, and MBIST CTRL3) are examples of BIST controller 110 of system 100.

BAP 210 includes ijTAG (internal joint test action group) NI (network interface) 212. ijTAG NI 212 can refer to an IEEE (Institute of Electrical and Electronics Engineers) Standard 1149.1, which is a standard specifying how to control and monitor pins of compliant devices on a PCB (printed circuit board)) or TAP or an IEEE Standard 1687, which allows boundary-scan TAP and TAP controller to access instruments that are embedded on-chip, which enables testing of more internal elements of circuits and chips.

BAP 210 includes sequencer CKA (clock A) 232, which is the sequencer for memory devices in clock domain A. In one example, BAP 210 also includes sequencer CKB (clock B) 234, which is the sequencer for memory devices in clock domain B. BAP 210 includes status generator (GEN) CKA (clock A) 242, which generates status for memory devices in clock domain A. In one example, BAP 210 includes status generator (GEN) CKB (clock B) 244, which generates status for memory devices in clock domain B.

MBIST is a self-testing and repair mechanism which tests the memories through an effective set of algorithms to detect the faults that could be present inside a typical memory cell, such as SAF (stuck-at fault), TDF (transition delay fault), CF (coupling fault) or NPSF (neighborhood pattern sensitive fault). The MBIST controllers provide the MBIST capability to system 200. The MBIST operations can use an inbuilt clock, address and data generators and read/write controller logic, to generate the test patterns for the test.

System 200 is illustrated with the four MBIST controllers mentioned above, but the system could have more or fewer controllers in different implementations. In one example, each MBIST controller has multiple interfaces (INTF) associated with it, each to couple to a memory device. As illustrated, MBIST CTRL0 and MBIST CTRL1 are both enabled based on clock A, while MBIST CTRL2 and MBIST CTRL3 are both enabled based on clock B.

MBIST CTRL0, MBIST CTRL1 runs on CLKA domain and, MBIST CTRL2, MBIST CTRL3 runs on CLKB domain. MBIST CTRL0 can test two memories attached to it, illustrated by the INTF interfaces under CLKA domain. MBIST CTRL1 can test two memories attached to it, illustrated by the INTF interfaces under CLKA domain. MBIST CTRL2 can test two memories attached to it, illustrated by the INTF interfaces under CLKB domain. MBIST CTRL3 can test two memories attached to it, illustrated by the INTF interfaces under CLKB domain. In one example, BAP 210 can control the testing of arrays in multiple clock domains.

System 200 illustrates various signals selectable against TAG instructions from ijTAG NI 212. In one example, certain signals are aggregated across all clock domains. Other signals are per clock domain. Examples of signals aggregated across clock domains can include sys_ctrl_done, sys_ctrl_pass, and sys_ctrl_ready.

Examples of signals that can be per clock domain can include sys_clock_*, sys_test_done_*, sys_test_pass_*, sys_test_ready_*, sys_reset_*, sys_test_init_*, sys_test_start_*, where the '*' represents either CKA or CKB.

System 200 also represents signals sys_ctrl_select, sys_algo_select, sys_opset_select, sys_step_select, sys_memory_select, sys_test_port_select, sys data inv_col add_bit select, sys data_inv_row add_bit select, sys_retention_test_phase, and so forth as other signals that represent system configuration. System 200 illustrates signals ijtag_select, ijtag_tck, and so forth as the signals that can be used to trigger ijTAG NI 212, which can be an alternative configuration to the system configuration signal just mentioned.

In one example, BAP 210 includes registers 220, which represent registers BAP 210 can use to store address information and to store functional data contents from the memory devices to be tested by the MBIST controllers. In one example, registers 220 enable BAP 210 to support periodic infield system testing. The periodic tests can be performed on the memory arrays of an SOC while the SOC is deployed in a server, data center, banking system, vehicle system, gaming system, or other device. The periodic testing does not cause any disruption or destruction to the existing functional data in the memories. BAP 210 can keep track of which address was the last one tested in a prior infield testing session.

System 200 does not specifically illustrate sensor devices. In one example, system 200 enables predictive infield memory repair in addition to performing infield periodic tests. The testing can provide information that the system processes to determine when a memory location is at risk of failure and can take action to prevent the loss of data before the failure occurs.

In one example, system 200 includes firmware interface 250, which provides a communication interface for BAP 210. The communication interface enables BAP 210 to send out the information to the host, to a user, or to an application.

For the infield testing to produce usable data, BAP 210 should communicate the information to external entity 252. Firmware interface 250 enables BAP 210 to provide communication to external entity 252, which can be a user, OS, or cloud. Firmware interface 250 represents a communications interface circuit of system 200 to report results of the in-field MBIST operations enabled through BAP 210. Firmware interface 250 represents a functional bus interface, seeing that existing DFT interfaces do not permit BAP 210 to communicate to the OS. Examples of functional bus interfaces can be or include AMBA (advanced microcontroller bus architecture), AXI (advanced extensible interface), APB (advanced peripheral bus), AHB (advanced high-performance bus), OCP (open core protocol) bus or other bus.

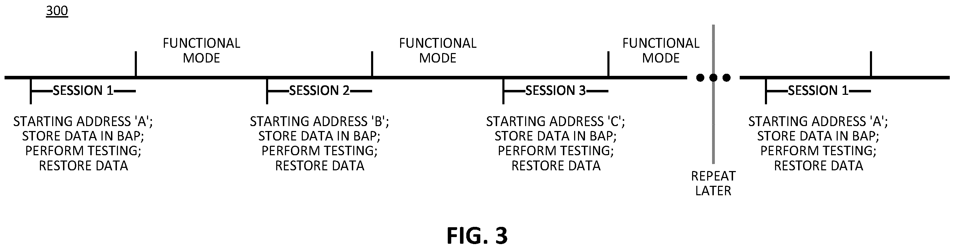

**Figure 3** is a sequence diagram of periodic in-field testing with a BIST system. Diagram 300 represents the timing for MBIST testing with a system in accordance with an example of system 100 or an example of system 200. The time periods or windows in diagram 300 are illustrated as being of a consistent time length. In one example, one or more of the time lengths are not the same between different sessions or between different functional modes.

As the number of applications increases, the different types of testing, including memory testing, cannot all fit in a single test window. As indicated above, the BAP can track the address reached in previous testing sessions. Thus, the system can periodically look at segments and swap data contents from locations in the memory device. For memory testing, the BAP can read out contents from the memory, the controller can then write testing data and check the test data, then the BAP can write the functional data contents back to the memory.

Diagram 300 illustrates an example of infield testing, with sessions of MBIST testing interweaved with functional modes in which the system uses the memory normally. Diagram 300 illustrates the infield testing performed as a sequence of test sessions. Diagram 300 illustrates the first three sessions needed to test all the memory address locations. There can be any number of sessions, depending on how long each testing session lasts and how many address locations are in the memory to be tested.

Diagram 300 illustrates Session 1 starting at Starting Address 'A', in which the system stores the data from the memory locally in the BAP, performs the testing on the memory locations, and then restores the data to the respective memory locations. Session 2 follows a similar pattern, starting with Starting Address 'B'. Session 3 follows the same pattern, starting with Starting Address 'C'. At some point in time later, the testing can repeat with a new Session 1, which can be Session (N+1) for a system that performs N periodic sessions. Between each test session, the system allows a functional mode in which the memory is used to store functional data.

Consider diagram 300 in light of an example of an infield test being performed on a memory with 1000 address locations. The infield testing is performed in periodic sessions until the full range of addresses for the memory have been tested. The range of addresses for a session is less than the total range of addresses for the memory.

In the infield periodic Session 1, the BAP directs performance of testing on the memory up to 250 locations. Thus, the BAP can save the 250th location and then proceed to the functional mode after the expiry of the infield periodic test mode.

In the infield periodic Session 2, the BAP can perform the tests from the 251st location up to the 500th location. Thus, the BAP can save the 500th location and then proceed to the functional mode after the expiry of the infield periodic test mode.

Similarly, in the infield periodic Session 3, the BAP can perform the tests from the 501st location up to 750th location. Thus, the BAP can save the 750th location and then proceed to the functional mode after the expiry of the infield periodic test mode.

In an infield periodic Session 4, the BAP can perform the tests from the 751st location up to the 1000th location. Thus, the BAP can save the 1000th location and then proceed to the functional mode after the expiry of the infield periodic test mode. If the 1000th location is the last location, Session 5 will be a new Session 1, starting again with the first memory location.

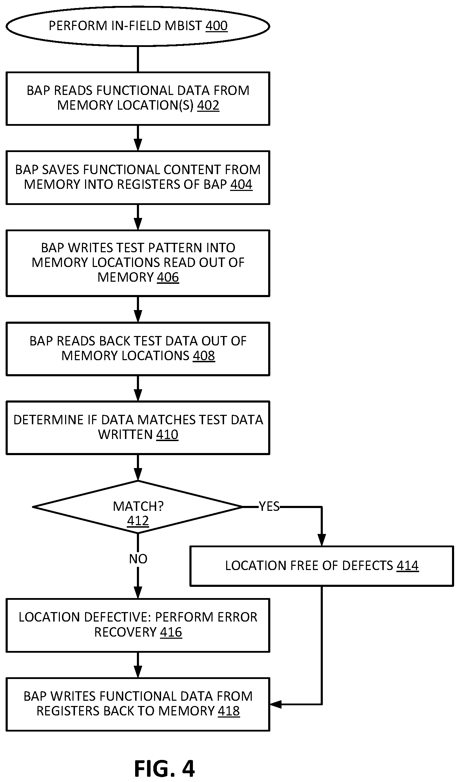

**Figure 4** is a flow diagram of an example of a process for performing in-field MBIST. Process 400 represents a process for performing in-field MBIST in accordance with an example of a system described above. For the process to be completed without destruction of the functional memory content, the BAP can support reading a particular number of memory locations, saving them locally in the BAP module, writing the test pattern, and reading back the test pattern before restoring the functional data contents.

In one example, the BAP reads the function content from one or more memory locations, at 402. In one example, the BAP saves the functional content from the memory locally in the registers of the BAP, at 404. In one example, the BAP writes a test pattern into the memory locations whose contents were read out of the memory, at 406. In one example, the BAP reads back the test data out of the memory locations, at 408.

The system can determine if the data written and read back matches the original test data, at 410. If the data matches, at 412 YES branch, the location is defect free, at 414. If the data does not match, at 412 NO branch, the location is defective, and in one example, the system can perform error recovery, at 416. The error recovery can include reporting the error to an external entity. The error recovery can include performing error correction on the data. After completing the memory testing, the BAP can write the functional data from the registers back to the same memory locations, at 418.

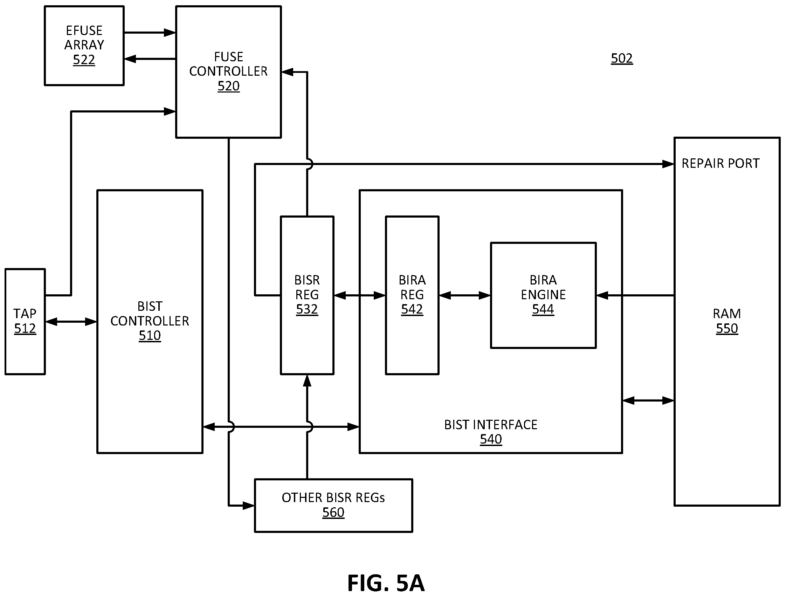

**Figures 5A-5B** are block diagrams of an example of a BIST interface for in-field predictive memory repair. Referring to Figure 5A, system 502 represents a system in accordance with an example of system 100 or an example of system 200. System 502 includes components directed to the predictive repair of memories based on a sensor interface.

System 502 includes BIST controller 510 coupled to BIST interface 540, which represents a BAP interface. RAM (random access memory) 550 represents a memory to be tested. In one example, RAM 550 includes redundancy to enable failover from a defective memory location to another memory location.

In one example, BIST interface 540 includes a BIRA (built-in redundancy analysis) module to calculate the repair signature based on the memory failure data and the implemented memory redundancy scheme. In one example, the BIRA module determines whether the memory is repairable in the production testing environments. The system can store the repair signature in the BIRA registers for further processing by the MBIST controller, such as BIST controller 510.

The BIRA module can include BIRA REG (registers) 542 and BIRA engine 544. The registers can store the memory redundancy information. In one example, system 502 includes BISR (built-in self repair) REG (registers) 532 to store the repair signatures. BIRA engine 544 can perform the analysis and the computations to make determines and direct how to perform any repairs to be made. RAM 550 can include a repair port to enable repair operations. In one example, BISR register 532 can provide information to the repair port to enable the repair of the memory.

System 502 illustrates TAP 512 coupled to BIST controller 510 and also coupled to fuse controller 520. In one example, the fuse controller can manage e-fuse (or eFuse) array 522. Fuse controller 520 can receive information from BISR registers 532. In one example, system 502 includes other BISR registers 560.

In accordance with system 502, in one example, the system can implement memory repair in two phases. The first phase is to analyze the failures diagnosed by BIST controller 510 during the test for repairable memories with BIRA engine 544. The second phase can be to determine the repair signature to repair the memories. All the repairable memories have repair registers which hold the repair signature.

In one example, the system passes the repair signature to the repair register's scan chain for subsequent Fusebox programming, which is located at the chip level. The reading and writing of a Fusebox is controlled through TAP 512. The dedicated repair registers scan chains connecting memories to fuses. The system can then scan repair information out of the scan chains, compressed, and burn the information on-the-fly into eFuse array 522 by applying high voltage pulses with fuse controller 520.

In one example, system 502 can perform memory repair in response to detection of a failure, as stated above. In one example, system 502 enables predictive repair, which could avoid the loss of data in the SOC the memory is a part of. In one example, system 502 gathers data from intelligent sensors as described above, which can enable predictive memory repair. The sensors have intelligence to communicate the health of the memories and send information to a firmware controller to trigger the controller to perform the repair.

In one example, the sensors have the threshold registers containing the values of the sensors that are safe. Thus, the threshold registers can contain the values of safe ranges, where beyond those ranges, the sensors can send an interrupt to the firmware controller. In one example, the firmware controller sends repair commands through the firmware bus and then through the firmware to the JTAG TAP bridge (FW2TAP). FW2TAP converts the firmware repair commands to TAP commands, which then triggers the BAP or MBIST to start the process of repair.

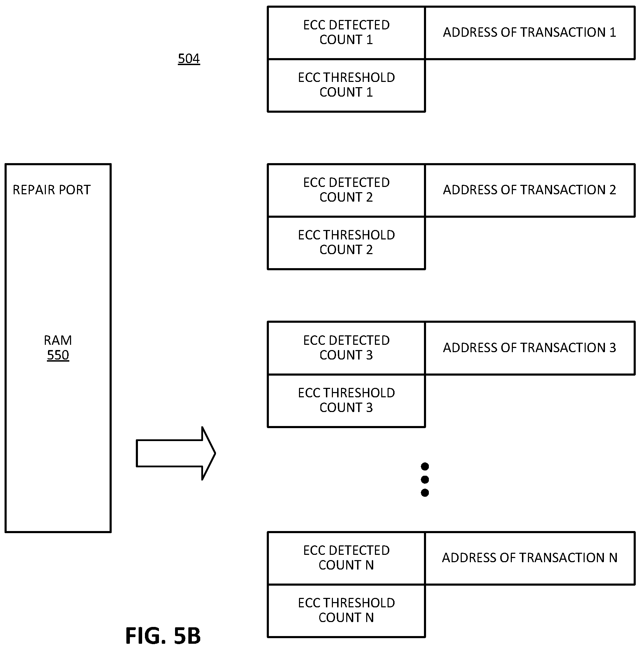

Referring to Figure 5B, system 504 illustrates components that can extend system 502. System 504 illustrates RAM 550 of system 502, as well as representations of the ECC (error checking and correction) components for the memory. System 504 can represent an in-hardware architecture to detect repairable memory ranges.

In one example, the sensors could be a number of error corrections made for a particular memory address. System 504 illustrates such a sensor as the ECC detected count, with Count 1 through Count N for the N respective transactions. In one example, system 504 also includes a respective ECC threshold count, for Count 1 to Count N.

In one example, the ECC error rate can be a sensor that supports predictive repair. In one example, the memory can include a digital aging sensor that can enable predictive repair. In general, the sensors detect and report anomalous behavior, which triggers predictive operation for repair.

If at any point in time one of the ECC detected counts is greater than its respective ECC threshold count, the particular address for that transaction can be provided to the BIRA as described above, for BIRA signature and repair commands through the firmware bus. In one example, system 504 enables repair not only on a live system while the SOC is deployed at the customer end, but also enables performing the repair before a fatal failure occurs.

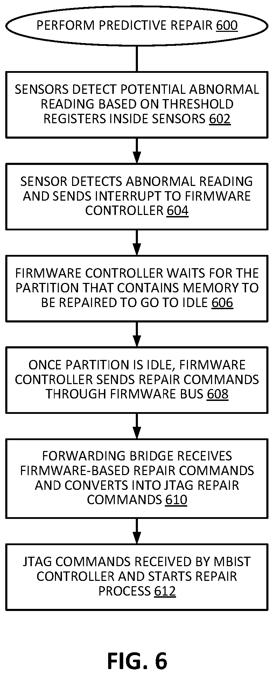

**Figure 6** is a flow diagram of an example of a process for performing in-field predictive memory repair. Process 600 represents a process for performing in-field predictive memory repair in accordance with an example of system 502 and system 504.

In one example, the system includes sensors embedded inside the memory, such as a digital aging sensor. In one example, the system includes sensors outside the memory, such as a monitor of the number of error correcting instances for the memory. In one example, the sensors are instantiated as intelligent sensors inside a partition. In one example, a sensor detects potential abnormal readings based on threshold registers inside the sensor, at 602.

In one example, when the sensor determines that the potentially abnormal reading is in fact an abnormal reading, the sensor can send an interrupt to the firmware controller, at 604. The firmware controller can then wait for the partition (e.g., USB (universal serial bus) controller) that contains the memory to be repaired, to go into an idle state, at 606. In one example, instead of waiting for an idle state, the firmware controller can inform the driver of the partition (e.g., the USB driver) to make the partition (e.g., the USB controller) idle.

Once the partition, in one example, the firmware controller detects the partition as idle and sends repair commands through the firmware bus, at 608. In one example, the system includes a forwarding bridge (e.g., an FW2TAP bridge) that receives the firmware-based repair commands and converts them into JTAG-based repair commands, at 610. The MBIST controller can receive the JTAG commands and start the repair process, at 612.

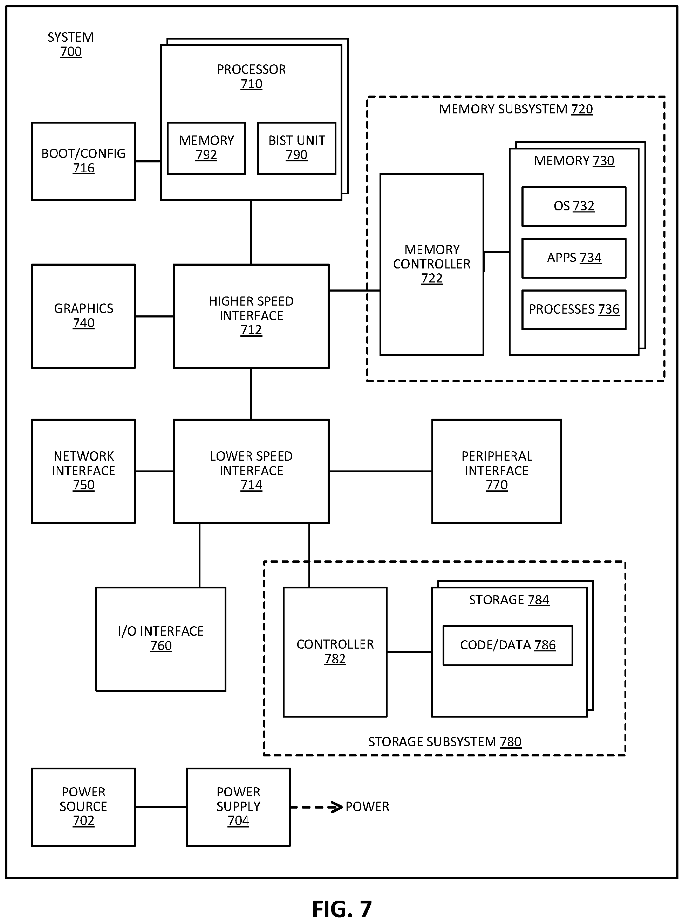

**Figure 7** is a block diagram of an example of a computing system in which in-field MBIST can be implemented. System 700 represents a computing device in accordance with any example herein, and can be a laptop computer, a desktop computer, a tablet computer, a server, a gaming or entertainment control system, embedded computing device, or other electronic device.

System 700 represents a system where processor 710 includes memory 792 and BIST unit 790 to manage in-field memory testing in accordance with any example herein. In one example, processor 710 represents an SOC. Memory 792 and BIST unit 790 are not necessarily located on the same physical IC (integrated circuit) die, although they can be.

System 700 includes processor 710 can include any type of microprocessor, central processing unit (CPU), graphics processing unit (GPU), processing core, or other processing hardware, or a combination, to provide processing or execution of instructions for system 700. Processor 710 can be a host processor device. Processor 710 controls the overall operation of system 700, and can be or include, one or more programmable general-purpose or special-purpose microprocessors, digital signal processors (DSPs), programmable controllers, application specific integrated circuits (ASICs), programmable logic devices (PLDs), or a combination of such devices.

System 700 includes boot/config 716, which represents storage to store boot code (e.g., basic input/output system (BIOS)), configuration settings, security hardware (e.g., trusted platform module (TPM)), or other system level hardware that operates outside of a host OS. Boot/config 716 can include a nonvolatile storage device, such as read-only memory (ROM), flash memory, or other memory devices.

In one example, system 700 includes interface 712 coupled to processor 710, which can represent a higher speed interface or a high throughput interface for system components that need higher bandwidth connections, such as memory subsystem 720 or graphics interface components 740. Interface 712 represents an interface circuit, which can be a standalone component or integrated onto a processor die. Interface 712 can be integrated as a circuit onto the processor die or integrated as a component on a system on a chip. Where present, graphics interface 740 interfaces to graphics components for providing a visual display to a user of system 700. Graphics interface 740 can be a standalone component or integrated onto the processor die or system on a chip. In one example, graphics interface 740 can drive a high definition (HD) display or ultra high definition (UHD) display that provides an output to a user. In one example, the display can include a touchscreen display. In one example, graphics interface 740 generates a display based on data stored in memory 730 or based on operations executed by processor 710 or both.

Memory subsystem 720 represents the main memory of system 700, and provides storage for code to be executed by processor 710, or data values to be used in executing a routine. Memory subsystem 720 can include one or more varieties of random-access memory (RAM) such as DRAM, 3DXP (three-dimensional crosspoint), or other memory devices, or a combination of such devices. Memory 730 stores and hosts, among other things, operating system (OS) 732 to provide a software platform for execution of instructions in system 700. Additionally, applications 734 can execute on the software platform of OS 732 from memory 730. Applications 734 represent programs that have their own operational logic to perform execution of one or more functions. Processes 736 represent agents or routines that provide auxiliary functions to OS 732 or one or more applications 734 or a combination. OS 732, applications 734, and processes 736 provide software logic to provide functions for system 700. In one example, memory subsystem 720 includes memory controller 722, which is a memory controller to generate and issue commands to memory 730. It will be understood that memory controller 722 could be a physical part of processor 710 or a physical part of interface 712. For example, memory controller 722 can be an integrated memory controller, integrated onto a circuit with processor 710, such as integrated onto the processor die or a system on a chip.

While not specifically illustrated, it will be understood that system 700 can include one or more buses or bus systems between devices, such as a memory bus, a graphics bus, interface buses, or others. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a Peripheral Component Interconnect (PCI) bus, a HyperTransport or industry standard architecture (ISA) bus, a small computer system interface (SCSI) bus, a universal serial bus (USB), or other bus, or a combination.

In one example, system 700 includes interface 714, which can be coupled to interface 712. Interface 714 can be a lower speed interface than interface 712. In one example, interface 714 represents an interface circuit, which can include standalone components and integrated circuitry. In one example, multiple user interface components or peripheral components, or both, couple to interface 714. Network interface 750 provides system 700 the ability to communicate with remote devices (e.g., servers or other computing devices) over one or more networks. Network interface 750 can include an Ethernet adapter, wireless interconnection components, cellular network interconnection components, USB (universal serial bus), or other wired or wireless standards-based or proprietary interfaces. Network interface 750 can exchange data over a network connection with a remote device, which can include sending data stored in memory or receiving data to be stored in memory.

In one example, system 700 includes one or more input/output (I/O) interface(s) 760. I/O interface 760 can include one or more interface components through which a user interacts with system 700 (e.g., audio, alphanumeric, tactile/touch, or other interfacing). Peripheral interface 770 can include any hardware interface not specifically mentioned above. Peripherals refer generally to devices that connect dependently to system 700. A dependent connection is one where system 700 provides the software platform or hardware platform or both on which operation executes, and with which a user interacts.

In one example, system 700 includes storage subsystem 780 to store data in a nonvolatile manner. In one example, in certain system implementations, at least certain components of storage 780 can overlap with components of memory subsystem 720. Storage subsystem 780 includes storage device(s) 784, which can be or include any conventional medium for storing large amounts of data in a nonvolatile manner, such as one or more magnetic, solid state, NAND, 3DXP, or optical based disks, or a combination. Storage 784 holds code or instructions and data 786 in a persistent state (i.e., the value is retained despite interruption of power to system 700). Storage 784 can be generically considered to be a "memory," although memory 730 is typically the executing or operating memory to provide instructions to processor 710. Whereas storage 784 is nonvolatile, memory 730 can include volatile memory (i.e., the value or state of the data is indeterminate if power is interrupted to system 700). In one example, storage subsystem 780 includes controller 782 to interface with storage 784. In one example controller 782 is a physical part of interface 714 or processor 710, or can include circuits or logic in both processor 710 and interface 714.

Power source 702 provides power to the components of system 700. More specifically, power source 702 typically interfaces to one or multiple power supplies 704 in system 700 to provide power to the components of system 700. In one example, power supply 704 includes an AC to DC (alternating current to direct current) adapter to plug into a wall outlet. Such AC power can be renewable energy (e.g., solar power) power source 702. In one example, power source 702 includes a DC power source, such as an external AC to DC converter. In one example, power source 702 or power supply 704 includes wireless charging hardware to charge via proximity to a charging field. In one example, power source 702 can include an internal battery or fuel cell source.

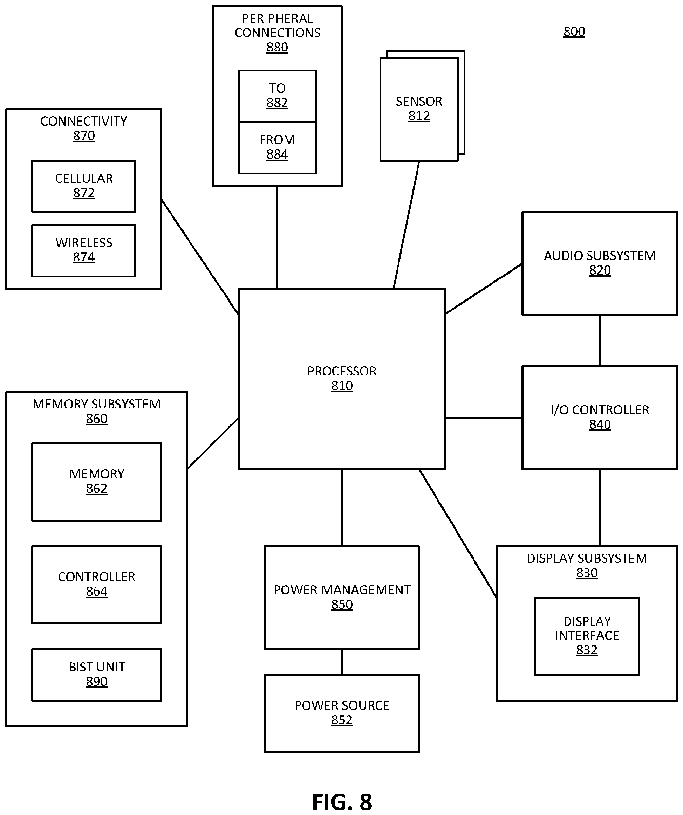

**Figure 8** is a block diagram of an example of a compact computing device in which in-field MBIST can be implemented. System 800 represents a compact computing device, such as an embedded computing device. It will be understood that certain of the components are shown generally, and not all components of such a device are shown in system 800.

System 800 represents a system where processor 810 includes memory 862. System 800 includes BIST unit 890 to manage in-field memory testing in accordance with any example herein. In one example, processor 810 represents an SOC. Memory 862 can represent memory resources on processor 810 or on an SOC of processor 810. BIST unit 890 is not necessarily located on the same physical IC die as the memory, although it can be.

System 800 includes processor 810, which performs the primary processing operations of system 800. Processor 810 can be a host processor device and can be referred to as a main processor device or a primary processor device. Processor 810 can include one or more physical devices, such as microprocessors, application processors, microcontrollers, programmable logic devices, or other processing means. The processing operations performed by processor 810 include the execution of an operating platform or operating system on which applications and device functions are executed. The processing operations include operations related to I/O (input/output) with a human user or with other devices, operations related to power management, operations related to connecting system 800 to another device, or a combination. The processing operations can also include operations related to audio I/O, display I/O, or other interfacing, or a combination. Processor 810 can execute data stored in memory. Processor 810 can write or edit data stored in memory.

In one example, system 800 includes one or more sensors 812. Sensors 812 represent embedded sensors or interfaces to external sensors, or a combination. Sensors 812 enable system 800 to monitor or detect one or more conditions of an environment or a device in which system 800 is implemented. Sensors 812 can include environmental sensors (such as temperature sensors, motion detectors, light detectors, cameras, chemical sensors (e.g., carbon monoxide, carbon dioxide, or other chemical sensors)), pressure sensors, accelerometers, gyroscopes, medical or physiology sensors (e.g., biosensors, heart rate monitors, or other sensors to detect physiological attributes), or other sensors, or a combination. Sensors 812 can also include sensors for biometric systems such as fingerprint recognition systems, face detection or recognition systems, or other systems that detect or recognize user features. Sensors 812 should be understood broadly, and not limiting on the many different types of sensors that could be implemented with system 800. In one example, one or more sensors 812 couples to processor 810 via a frontend circuit integrated with processor 810. In one example, one or more sensors 812 couples to processor 810 via another component of system 800.

In one example, system 800 includes audio subsystem 820, which represents hardware (e.g., audio hardware and audio circuits) and software (e.g., drivers, codecs) components associated with providing audio functions to the computing device. Audio functions can include speaker or headphone output, as well as microphone input. Devices for such functions can be integrated into system 800, or connected to system 800. In one example, a user interacts with system 800 by providing audio commands that are received and processed by processor 810.

Display subsystem 830 represents hardware (e.g., display devices) and software components (e.g., drivers) that provide a visual display for presentation to a user. In one example, the display includes tactile components or touchscreen elements for a user to interact with the computing device. Display subsystem 830 includes display interface 832, which includes the particular screen or hardware device used to provide a display to a user. In one example, display interface 832 includes logic separate from processor 810 (such as a graphics processor) to perform at least some processing related to the display. In one example, display subsystem 830 includes a touchscreen device that provides both output and input to a user. In one example, display subsystem 830 includes a high definition (HD) or ultra-high definition (UHD) display that provides an output to a user. In one example, display subsystem includes or drives a touchscreen display. In one example, display subsystem 830 generates display information based on data stored in memory or based on operations executed by processor 810 or both.

I/O controller 840 represents hardware devices and software components related to interaction with a user. I/O controller 840 can operate to manage hardware that is part of audio subsystem 820, or display subsystem 830, or both. Additionally, I/O controller 840 illustrates a connection point for additional devices that connect to system 800 through which a user might interact with the system. For example, devices that can be attached to system 800 might include microphone devices, speaker or stereo systems, video systems or other display device, keyboard or keypad devices, buttons/switches, or other I/O devices for use with specific applications such as card readers or other devices.

As mentioned above, I/O controller 840 can interact with audio subsystem 820 or display subsystem 830 or both. For example, input through a microphone or other audio device can provide input or commands for one or more applications or functions of system 800. Additionally, audio output can be provided instead of or in addition to display output. In another example, if display subsystem includes a touchscreen, the display device also acts as an input device, which can be at least partially managed by I/O controller 840. There can also be additional buttons or switches on system 800 to provide I/O functions managed by I/O controller 840.

In one example, I/O controller 840 manages devices such as accelerometers, cameras, light sensors or other environmental sensors, gyroscopes, global positioning system (GPS), or other hardware that can be included in system 800, or sensors 812. The input can be part of direct user interaction, as well as providing environmental input to the system to influence its operations (such as filtering for noise, adjusting displays for brightness detection, applying a flash for a camera, or other features).

In one example, system 800 includes power management 850 that manages battery power usage, charging of the battery, and features related to power saving operation. Power management 850 manages power from power source 852, which provides power to the components of system 800. In one example, power source 852 includes an AC to DC (alternating current to direct current) adapter to plug into a wall outlet. Such AC power can be renewable energy (e.g., solar power, motion based power). In one example, power source 852 includes only DC power, which can be provided by a DC power source, such as an external AC to DC converter. In one example, power source 852 includes wireless charging hardware to charge via proximity to a charging field. In one example, power source 852 can include an internal battery or fuel cell source.

Memory subsystem 860 includes memory device(s) 862 for storing information in system 800. Memory subsystem 860 can include nonvolatile (state does not change if power to the memory device is interrupted) or volatile (state is indeterminate if power to the memory device is interrupted) memory devices, or a combination. Memory 860 can store application data, user data, music, photos, documents, or other data, as well as system data (whether long-term or temporary) related to the execution of the applications and functions of system 800. In one example, memory subsystem 860 includes memory controller 864 (which could also be considered part of the control of system 800, and could potentially be considered part of processor 810). Memory controller 864 includes a scheduler to generate and issue commands to control access to memory device 862.

Connectivity 870 includes hardware devices (e.g., wireless or wired connectors and communication hardware, or a combination of wired and wireless hardware) and software components (e.g., drivers, protocol stacks) to enable system 800 to communicate with external devices. The external device could be separate devices, such as other computing devices, wireless access points or base stations, as well as peripherals such as headsets, printers, or other devices. In one example, system 800 exchanges data with an external device for storage in memory or for display on a display device. The exchanged data can include data to be stored in memory, or data already stored in memory, to read, write, or edit data.

Connectivity 870 can include multiple different types of connectivity. To generalize, system 800 is illustrated with cellular connectivity 872 and wireless connectivity 874. Cellular connectivity 872 refers generally to cellular network connectivity provided by wireless carriers, such as provided via GSM (global system for mobile communications) or variations or derivatives, CDMA (code division multiple access) or variations or derivatives, TDM (time division multiplexing) or variations or derivatives, LTE (long term evolution - also referred to as "4G"), 5G, or other cellular service standards. Wireless connectivity 874 refers to wireless connectivity that is not cellular, and can include personal area networks (such as Bluetooth), local area networks (such as WiFi), or wide area networks (such as WiMax), or other wireless communication, or a combination. Wireless communication refers to transfer of data through the use of modulated electromagnetic radiation through a non-solid medium. Wired communication occurs through a solid communication medium.

Peripheral connections 880 include hardware interfaces and connectors, as well as software components (e.g., drivers, protocol stacks) to make peripheral connections. It will be understood that system 800 could both be a peripheral device ("to" 882) to other computing devices, as well as have peripheral devices ("from" 884) connected to it. System 800 commonly has a "docking" connector to connect to other computing devices for purposes such as managing (e.g., downloading, uploading, changing, synchronizing) content on system 800. Additionally, a docking connector can allow system 800 to connect to certain peripherals that allow system 800 to control content output, for example, to audiovisual or other systems.

In addition to a proprietary docking connector or other proprietary connection hardware, system 800 can make peripheral connections 880 via common or standards-based connectors. Common types can include a Universal Serial Bus (USB) connector (which can include any of a number of different hardware interfaces), DisplayPort including MiniDisplayPort (MDP), High Definition Multimedia Interface (HDMI), or other type.

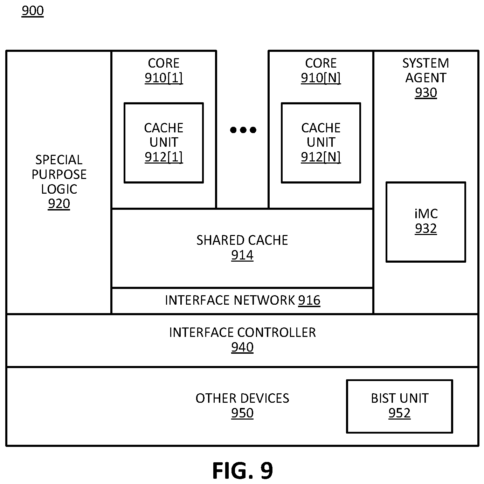

**Figure 9** is a block diagram of an example of an SOC in which in-field MBIST can be implemented. System 900 illustrates an example of a processor or an SOC that has one or more processor cores. System 900 includes BIST unit 952. BIST unit 952 can manage in-field memory testing in accordance with any example herein.

System 900 includes one or more cores, represented by core 910[1], ... core 910[N], collectively cores 910. Thus, system 900 can be a multicore processor system. System 900 includes system agent 930, which represents system agent unit circuitry to manage memory access. In one example, system agent 930 includes iMC (integrated memory controller) 932. In one example, system 900 includes one or more interface controller 940, which can represent interface controller unit circuitry. System 900 can include special purpose logic 920.

Different implementations of system 900 can include: a CPU with special purpose logic 920 being integrated graphics, scientific throughput logic (which may include one or more cores), and cores 910 can be one or more general purpose cores (e.g., general purpose in-order cores, general purpose out-of-order cores, or a combination of the two); a coprocessor with cores 910 being a large number of special purpose cores intended primarily for graphics or scientific computations and throughput; or a coprocessor with cores 910 being a large number of general purpose in-order cores. Thus, system 900 can include or can be a general-purpose processor, coprocessor or special-purpose processor, such as, for example, a network or communication processor, compression engine, graphics processor, GPGPU (general purpose graphics processing unit), a high throughput many integrated core (MIC) coprocessor (including 30 or more cores), embedded processor, or other processor system. The processor can be implemented on one or more chips, such as multiple chiplets connected through a chiplet communication network. The processor can be a part of or be implemented on one or more substrates using any of a number of process technologies, such as, for example, CMOS (complementary metal oxide semiconductor), BiCMOS (bipolar CMOS), PMOS (P-type metal oxide semiconductor), or NMOS (N-type metal oxide semiconductor).

In one example, system 900 has a memory hierarchy including one or more levels of cache illustrated by cache unit 912[1], ... cache unit 912[N], collectively cache units 912. Cache units 912 can be circuitry on cores 910. The memory hierarchy can include the cache and external memory (not shown) coupled to iMC 932. In one example, system 900 has mid-level caches, such as level 2 (L2), level 3 (L3), level 4 (L4), or other levels of cache, such as a last level cache (LLC), or combinations of cache levels.

In one example, system 900 includes interface network circuitry 916, which can be, for example, a ring interconnect, which interfaces special purpose logic 920 (e.g., integrated graphics logic), shared cache 914, and system agent 930. Alternative examples can apply any number of techniques for interfacing such units. In one example, coherency is maintained between one or more of shared cache 914 and cores 910. In one example, interface controller 940 couples cores 910 to one or more other devices 950 such as I/O (input/output) devices, storage, one or more communication devices (e.g., wireless networking, wired networking, etc.), and so forth.

In one example, one or more cores 910 are capable of multi-threading. System agent 930 includes components for coordinating and operating cores 910 related to multithreading. System agent 930 can include, for example, PCU (power control unit) circuitry or display unit circuitry (not shown). The PCU can be or include logic and components needed for regulating the power state of cores 910 or of special purpose logic 920 (e.g., integrated graphics logic), or both. The display unit circuitry can drive one or more externally connected displays.

Cores 910 can be homogenous in terms of ISA (instruction set architecture). Alternatively, cores 910 can be heterogeneous in terms of ISA, where a subset of cores 910 can execute an ISA, while other cores can execute only a subset of that ISA or another ISA.

In general with respect to the descriptions herein, in one aspect, an apparatus includes: a memory built-in self-test (MBIST) controller to perform a built-in self-test (BIST) of a memory device; and a BIST adaptive port (BAP) interface circuit, the BAP interface circuit including registers to store contents of the memory device during an in-field MBIST on the memory device; wherein the MBIST controller is to store contents for selected test addresses in the registers, perform an in-field MBIST operation on the selected test addresses, and then restore the contents for the selected test addresses from the registers.

In accordance with an example of the apparatus, the MBIST controller is to trigger an error repair operation in response to detection of an error in the memory device. In accordance with any preceding example of the apparatus, in one example, the MBIST controller is to perform error prediction for the memory device based on a signal from a sensor. In accordance with any preceding example of the apparatus, in one example, the MBIST controller is to periodically trigger MBIST operations on a range of addresses for an MBIST session, wherein the range of addresses is less than a total range of addresses of the memory device. In accordance with any preceding example of the apparatus, in one example, the registers include at least one address register to store an address location to indicate a next address to test in a subsequent MBIST session. In accordance with any preceding example of the apparatus, in one example, the BAP interface circuit comprises a circuit on a system on a chip of a main processor device. In accordance with any preceding example of the apparatus, in one example, the BAP interface circuit comprises a circuit on a central processing unit (CPU) die. In accordance with any preceding example of the apparatus, in one example, the apparatus includes a communications interface circuit to report results of the in-field MBIST operation to a location remote from the MBIST controller.

In general with respect to the descriptions herein, in one aspect, a system includes: a processor device; a memory device coupled to the processor device; and a memory built-in self-test (MBIST) unit, including an MBIST controller to perform a built-in self-test (BIST) of the memory device; and a BIST adaptive port (BAP) interface circuit, the BAP interface circuit including registers to store contents of the memory device during an in-field MBIST on the memory device; wherein the MBIST controller is to store contents for selected test addresses in the registers, perform an in-field MBIST operation on the selected test addresses, and then restore the contents for the selected test addresses from the registers.

In accordance with an example of the system, in one example, the MBIST controller is to trigger an error repair operation in response to detection of an error in the memory device. In accordance with any preceding example of the system, in one example, the MBIST controller is to perform error prediction for the memory device based on a signal from a sensor. In accordance with any preceding example of the system, in one example, the MBIST controller is to periodically trigger MBIST operations on a range of addresses for an MBIST session, wherein the range of addresses is less than a total range of addresses of the memory device. In accordance with any preceding example of the system, in one example, the registers include at least one address register to store an address location to indicate a next address to test in a subsequent infield periodic testing MBIST session. In accordance with any preceding example of the system, in one example, the BAP interface circuit comprises a circuit on a system on a chip of the processor device. In accordance with any preceding example of the system, in one example, the processor device comprises a central processing unit (CPU) and the BAP interface circuit comprises a circuit on a die of the CPU. In accordance with any preceding example of the system, in one example, the processor device comprises a central processing unit (CPU) and the memory device comprises a memory circuit on a die of the CPU. In accordance with any preceding example of the system, in one example, the system includes a communications interface circuit to report results of the in-field MBIST operation to a location remote from the MBIST controller. In accordance with any preceding example of the system, in one example, the processor device comprises a multicore processor. In accordance with any preceding example of the system, in one example, the system includes a display communicatively coupled to the processor device. In accordance with any preceding example of the system, in one example, the system includes a battery to power the system. In accordance with any preceding example of the system, in one example, the system includes a network interface circuit to couple with a remote device over a network connection.

In general with respect to the descriptions herein, in one aspect, a method includes: storing contents of selected test addresses of a memory device in a register of a built-in self-test (BIST) adaptive port (BAP) interface circuit; performing an in-field memory built-in self-test (MBIST) operation on the selected test addresses; and then restoring the contents for the selected test addresses from the registers.

In accordance with an example of the method, the method includes triggering an error repair operation in response to detection of an error in the memory device. In accordance with any preceding example of the method, in one example, the method includes performing error prediction for the memory device based on a signal from a sensor. In accordance with any preceding example of the method, in one example, performing the in-field MBIST operation comprises periodically triggering MBIST operations on a range of addresses for an MBIST session, wherein the range of addresses is less than a total range of addresses of the memory device. In accordance with any preceding example of the method, in one example, the method includes storing an address location to indicate a next address to test in a subsequent MBIST session. In accordance with any preceding example of the method, in one example, the method includes reporting results of the in-field MBIST operation over a communications interface of the BAP to a location remote from the BAP.

Flow diagrams as illustrated herein provide examples of sequences of various process actions. The flow diagrams can indicate operations to be executed by a software or firmware routine, as well as physical operations. A flow diagram can illustrate an example of the implementation of states of a finite state machine (FSM), which can be implemented in hardware and/or software. Although shown in a particular sequence or order, unless otherwise specified, the order of the actions can be modified. Thus, the illustrated diagrams should be understood only as examples, and the process can be performed in a different order, and some actions can be performed in parallel. Additionally, one or more actions can be omitted; thus, not all implementations will perform all actions.

To the extent various operations or functions are described herein, they can be described or defined as software code, instructions, configuration, and/or data. The content can be directly executable ("object" or "executable" form), source code, or difference code ("delta" or "patch" code). The software content of what is described herein can be provided via an article of manufacture with the content stored thereon, or via a method of operating a communication interface to send data via the communication interface. A machine readable storage medium can cause a machine to perform the functions or operations described, and includes any mechanism that stores information in a form accessible by a machine (e.g., computing device, electronic system, etc.), such as recordable/non-recordable media (e.g., read only memory (ROM), random access memory (RAM), magnetic disk storage media, optical storage media, flash memory devices, etc.). A communication interface includes any mechanism that interfaces to any of a hardwired, wireless, optical, etc., medium to communicate to another device, such as a memory bus interface, a processor bus interface, an Internet connection, a disk controller, etc. The communication interface can be configured by providing configuration parameters and/or sending signals to prepare the communication interface to provide a data signal describing the software content. The communication interface can be accessed via one or more commands or signals sent to the communication interface.

Various components described herein can be a means for performing the operations or functions described. Each component described herein includes software, hardware, or a combination of these. The components can be implemented as software modules, hardware modules, special-purpose hardware (e.g., application specific hardware, application specific integrated circuits (ASICs), digital signal processors (DSPs), etc.), embedded controllers, hardwired circuitry, etc.

Besides what is described herein, various modifications can be made to what is disclosed and implementations of the invention without departing from their scope. Therefore, the illustrations and examples herein should be construed in an illustrative, and not a restrictive sense. The scope of the invention should be measured solely by reference to the claims that follow.

## Claims

1. A system for testing memory, comprising:
a processor device;
a memory device coupled to the processor device; and
a memory built-in self-test (MBIST) unit, including
an MBIST controller to perform a built-in self-test (BIST) of the memory device; and
a BIST adaptive port (BAP) interface circuit, the BAP interface circuit including registers to store contents of the memory device during an in-field MBIST on the memory device;
wherein the MBIST controller is to store contents for selected test addresses in the registers, perform an in-field MBIST operation on the selected test addresses, and then restore the contents for the selected test addresses from the registers.

2. The system of claim 1, wherein the MBIST controller is to trigger an error repair operation in response to detection of an error in the memory device.

3. The system of either of claims 1 or 2, wherein the MBIST controller is to perform error prediction for the memory device based on a signal from a sensor.

4. The system of any of claims 1 to 3, wherein the MBIST controller is to periodically trigger MBIST operations on a range of addresses for an MBIST session, wherein the range of addresses is less than a total range of addresses of the memory device.

5. The system of claim 4, wherein the registers include at least one address register to store an address location to indicate a next address to test in a subsequent infield periodic testing MBIST session.

6. The system of any of claims 1 to 5, wherein the BAP interface circuit comprises a circuit on a system on a chip of the processor device.

7. The system of any of claims 1 to 6, wherein the processor device comprises a central processing unit (CPU) and the BAP interface circuit comprises a circuit on a die of the CPU.

8. The system of any of claims 1 to 7, wherein the processor device comprises a central processing unit (CPU) and the memory device comprises a memory circuit on a die of the CPU.

9. The system of any of claims 1 to 8, further comprising a communications interface circuit to report results of the in-field MBIST operation to a location remote from the MBIST controller.

10. The system of any of claims 1 to 9,
wherein the processor device comprises a multicore processor;
further comprising a display communicatively coupled to the processor device; or
further comprising a battery to power the system.
